# EUROPÄISCHE PATENTSCHRIFT

(11) **EP 2 952 989 B1**
(45) Veröffentlichungstag und Bekanntmachung des Hinweises auf die Patenterteilung: **21.02.2018**
(21) Anmeldenummer: 15170497.0
(22) Anmeldetag: 03.06.2015
(51) Int. Cl.: G05B 19/4069, G05B 19/418

(54) **VERFAHREN ZUR BERECHNUNG EINER OPTIMIERTEN TRAJEKTORIE**
METHOD FOR CALCULATING AN OPTIMISED TRAJECTORY
PROCÉDÉ DE CALCUL D'UNE TRAJECTOIRE OPTIMISÉE

(30) Priorität: 03.06.2014 EP 14170951
(43) Veröffentlichungstag der Anmeldung: 09.12.2015
(73) Patentinhaber: Siemens Aktiengesellschaft, 80333 München (DE)
(72) Erfinder: Bonay, Alexandre, 91056 Erlangen (DE); Hoja, Stephan, 90556 Cadolzbrug (DE); Knoche, Frank, 51503 Rösrath (DE); Lorenz, Ulrich Wolfgang Dr., 10709 Berlin (DE); Meier, Michael, 91052 Erlangen (DE); Schäufele, Stephan, 91052 Erlangen (DE)

(56) Entgegenhaltungen:
- EP-A1- 2 254 013
- WO-A1-2014/063262
- DE-A1-102005 024 822
- DE-A1-102012 110 508
- DE-B3-102012 112 172
- DE-C1- 10 063 089

## Beschreibung

Die Erfindung betrifft ein Verfahren zur Berechnung einer optimierten Trajektorie eines Bauteils. Weiter betrifft die Erfindung ein Computerprogrammpaket zur Durchführung eines solchen Verfahrens. Zudem betrifft die Erfindung eine Steuerungseinrichtung, die ein solches Verfahren durchführt, sowie eine Produktionsmaschine, insbesondere eine Presse, mit einer solchen Steuerung.

Pressen werden in der industriellen Fertigung mannigfach zur Bearbeitung von Bauteilen, insbesondere von Blechen, beispielsweise zur Herstellung von Karosserieteilen in der Automobilindustrie, eingesetzt. Produktionsmaschinen, insbesondere Pressen, werden meist automatisiert bestückt. Die Bestückung der Produktionsmaschine mit einem Bauteil erfolgt durch eine Halterung, wobei die Halterung das Bauteil aufnimmt und in die Produktionsmaschine einbringt. Dieselbe Halterung oder eine weitere Halterung nimmt nach dem Durchlauf des Produktionsverfahrens in der Produktionsmaschine das Bauteil wieder heraus.

WO 2014/063262 A1 und DE 10 2005 024 882 A1 offenbaren Verfahren zur Optimierung von Transportbewegungen.

Insbesondere bei Pressen ergibt sich das Problem beim automatisierten Einbringen des Bauteils mittels einer Halterung, dass das Bauteil nur in einem engen Bereich in die Presse eingebracht werden kann. Um eine Kollision des Bauteils mit der Presse, insbesondere den Presswerkzeugen, zu verhindern, ist eine geeignete Bahnkurve erforderlich. Eine solche Bahnkurve muss vor der Bestückung der Presse mit dem Bauteil regelmäßig manuell erstellt werden. Dazu werden Geometrieparameter der Presse und ggf. weitere Parameter als Randbedingungen zur Berechnung einer Bahnkurve mittels eines Simulationsprogramms eingesetzt. Um eine simulierte Bahnkurve zu verbessern, wurde die Bahnkurve durch qualifiziertes Personal verändert. Verbesserungen der Bahnkurve sind jedoch mühsam und bedürfen eines erfahrenen und qualifizierten Personals. Aufgabe der Erfindung ist es daher, ein Verfahren zur automatisierten Optimierung der Berechnung einer Bahnkurve oder Trajektorie bereitzustellen.

Weiter ist es Aufgabe der Erfindung, die Erstellung einer optimierten Trajektorie für den Benutzer intuitiv und einfach zu gestalten.

Die Aufgabe wird mittels eines Verfahrens nach Anspruch 1 gelöst. Weiter wird die Aufgabe mittels eines Computerprogrammprodukt gemäß Anspruch 8 gelöst.

Vorteilhafte Ausgestaltungen des Verfahrens sind in den abhängigen Ansprüchen beschrieben.

Unter einer Produktionsmaschine versteht man eine Presse, insbesondere eine Servopresse, eine Crimpvorrichtung, eine Bearbeitungsmaschine und/oder eine Verpackungsmaschine. Die Erfindung kann auch in einer Werkzeugmaschine angewandt werden. Vorteilhaft ist einer solchen Produktionsmaschine eine Beförderungseinrichtung zugeordnet.

Unter einem Bauteil versteht man insbesondere ein Blech, ein Werkstück, ein Halbzeug, ein Kunststoffteil oder ein noch nicht fertiges Produkt, das einer Produktionsmaschine zugeführt wird, um dessen Eigenschaften zu verändern. Ein Bauteil kann insbesondere ein, vorzugsweise noch umzuformendes, Karosserieteil, beispielsweise eines Kraftfahrzeugs, sein. Nach der Veränderung der Eigenschaften, vorzugsweise der Form des Bauteils, wird das Bauteil wieder aus der Produktionsmaschine entfernt. Zur Bestückung und/oder zur Entnahme des Bauteils ist die Beförderungseinrichtung vorgesehen.

Unter einer Trajektorie versteht man einen räumlichen Verlauf einer Halterung und/oder eines Bauteils, insbesondere in die Produktionsmaschine hinein oder aus der Produktionsmaschine hinaus. Die Trajektorie beschreibt weiter die räumliche Ausrichtung des Bauteils und/oder die räumliche Ausrichtung der Halterung. Es ist auch möglich, mittels einer Halterung mehrere Bauteile zu transportieren und somit in die Produktionsmaschine einzubringen oder aus der Produktionsmaschine wieder zu entfernen.

Eine Trajektorie ist eine Raumkurve, wobei einzelne Punkte der Raumkurve mit weiteren Größen verknüpft sind, wobei die Raumkurve vorteilhaft in einer Datei ablegbar und speicherbar ist, wobei die Raumpunkte die Orte der Halterung und/oder des Bauteils, Ausrichtung der Halterung und/oder des Bauteils aufweisen. Die weiteren Größen sind z.B. die Zeitpunkte und/ oder Geschwindigkeiten, die den einzelnen Punkten der Raumkurve zugeordnet sind.

Eine Trajektorie ist vorteilhaft durch diskrete Punkte, denen ggf. die weiteren Größen zugeordnet sind, oder durch Koeffizienten einer Funktion, insbesondere Entwicklungskoeffizienten einer Reihendarstellung einer Funktion, darstellbar und/ oder speicherbar. Entwicklungskoeffizienten sind Koeffizienten, die sich aus einer vorher definierten Reihendarstellung der Trajektorie, beispielsweise einer Taylor-Reihe, einer Laurent-Reihe oder einer Fourier-Reihe der Trajektorie, ergeben. Mit dem Begriff "Trajektorie" wird im Folgenden eine erste Trajektorie, eine weitere Trajektorie oder eine optimierte Trajektorie bezeichnet.

Unter einer ersten Trajektorie versteht man eine Trajektorie, die ohne eine Simulation oder in einer ersten Simulation mit dem Simulationsprogramm erstellt worden ist. Die erste Trajektorie wird insbesondere mittels einem, dafür geeigneten Computerprogramm, wie einem CAD Programm, an Randbedingungen angepasst. Vorteilhaft ist eine erste Trajektorie beispielsweise manuell erzeugt und/oder mittels eines Simulationsprogrammes an Randbedingungen angepasst. Die erste Trajektorie wird beispielsweise derart erstellt, dass ein Bauteil gerade nicht an den Rändern der Produktionsmaschine anstößt, ggf. mit einer geringen Änderung der Ausrichtung in eine Produktionsmaschine eingeführt wird und/oder mit einer geringen Geschwindigkeit in die Produktionsmaschine eingebracht wird oder aus der Produktionsmaschine entnommen wird.

Eine weitere Trajektorie ist eine Trajektorie, welche mit Hilfe einer Optimierungsroutine und/oder mit Hilfe eines Simulationsprogramms verändert worden ist. Einer weiteren Trajektorie ist ein veränderter Parameter zuordenbar. Eine weitere Trajektorie geht aus einer ersten Trajektorie oder einer weiteren Trajektorie durch eine Veränderung hervor.

Unter einer optimierten Trajektorie versteht man eine Trajektorie, welche aus einem extremalen Parameter, beispielsweise einer maximal erreichbaren Geschwindigkeit oder einer maximal erreichbaren Hubzahl, erzeugt worden ist und ggf. an die Randbedingungen angepasst worden ist. Eine optimierte Trajektorie geht meist aus einer weiteren Trajektorie hervor, welche zumindest einmal verändert/optimiert worden ist. Die Anpassung an die Randbedingungen erfolgt mit Hilfe des Simulationsprogramms. Eine optimierte Trajektorie zeichnet beispielsweise aus, dass entlang der extremalen Trajektorie das Bauteil besonders schnell in die Produktionsmaschine eingelegt und/oder aus der Produktionsmaschine entnommen werden kann.

Eine optimierte Trajektorie kann auch auszeichnen, dass die Zeit, die für die Zuführung des Bauteils in die Produktionsmaschine und/oder zur Entnahme des Bauteils aus der Produktionsmaschine und/oder zur Überführung des Bauteils an einen anderen Ort minimal ist.

Eine optimierte Trajektorie kann auch auszeichnen, dass die Zeitdauer, die für die Zuführung des Bauteils in die Produktionsmaschine und/oder zur Entnahme des Bauteils aus der Produktionsmaschine und/oder zur Überführung des Bauteils an einen anderen Ort gerade der Zeitdauer entspricht, welche die Produktionsmaschine für einen Zyklus bei einer maximalen Betriebsgeschwindigkeit benötigt.

Die Form einer optimierten Trajektorie hängt ggf. von der Geschwindigkeit ab, mit der das Bauteil und/oder die Halterung die Trajektorie durchläuft. Das Bauteil ist hierbei an der Halterung befestigt. Die Form der Trajektorie und/oder der vorteilhaften Ausrichtung des Bauteils und/oder der Halterung kann sich deshalb ändern, da Belastungen auf das Bauteil und/ oder die Halterung aufgrund von Beschleunigung derselben die Form und/oder die Position des Bauteils und/oder der Halterung durch Krafteinwirkung verändern.

Randbedingungen orientieren sich an den Ausmaßen und Größen der Produktionsmaschine, des Bauteils und/oder der Halterung, sowie ggf. einzuhaltenden Sicherheitsabständen von dem Bauteil zur Oberfläche der Produktionsmaschine. Randbedingungen können als Bereiche im Raum formuliert sein, in die das Bauteil nicht eindringen darf. Randbedingungen können auch Bereiche sein, in denen die erste Trajektorie, die weiteren Trajektorien sowie die optimierte Trajektorie verändert werden können. Gemäß dem hier beschriebenen Beispiel sind beispielsweise die Randbedingungen als maximale und minimale Parameter formuliert, zwischen denen sich die (veränderten) Parameter bewegen dürfen. Dabei bestehen ggf. Abhängigkeiten der maximalen und der minimalen Werte der (veränderten) Parameter mit Werten weiterer (veränderter) Parameter. Die Trajektorien verlaufen dann vorteilhaft in Bereichen, welche durch die minimalen und/oder maximalen Werte der (veränderten) Parameter definiert sind.

Falls die Werkzeuge der Produktionsmaschine sich während des Einbringens des Bauteils in die Produktionsmaschine oder der Entnahme des Bauteils aus der Produktionsmaschine bewegt, sind die Randbedingungen von der Zeit abhängig.

Falls beispielsweise ein Presswerkzeug einer Presse eine periodische Bewegung durchführt, und diese nicht während des Einbringens des Bauteils in die Presse und/oder der Entnahme des Bauteils aus der Presse gestoppt wird, so weist die Randbedingung eine periodische Zeitabhängigkeit auf.

Randbedingungen können auch maximale Drehzahlen von Motoren, maximale Hubzahlen der Presse, maximale Beschleunigungen des Bauteils und/oder der Halterung, minimale Durchlaufzeiten sowie bewegungsabhängige Verformungen der Halterung und/oder des Bauteils aufweisen.

Bei einer Nichteinhaltung von Randbedingungen kann es zu einer unvorhergesehenen Kollision des Bauteils mit der Produktionsmaschine, insbesondere mit einem Werkzeug der Produktionsmaschine kommen.

Unter einem Parameter versteht man eine optimierbare Größe, oder eine Menge von optimierbaren Größen, welche eine Eigenschaft einer oben ausgeführten Bahnkurve ist/sind. Ein Parameter kann eine Geschwindigkeit, in der eine Halterung und/ oder ein Bauteil die Trajektorie durchläuft, eine Durchlaufzeit und/oder eine Hubzahl bei einer Presse sein.

Der Parameter oder die Komponenten des Parameters sowie der veränderte Parameter oder die Komponenten des veränderten Parameters sind vorteilhaft anordenbar. Die Anzahl der Komponenten des Parameters bzw. des veränderten Parameters orientieren sich vorteilhaft an der Trajektorie und kann von Trajektorie zu Trajektorie schwanken.

Unter einem veränderten Parameter versteht man einen Parameter, der aus einer weiteren Trajektorie hervorgeht und/oder der, insbesondere durch die Optimierungsroutine, verändert wurde. Anhand eines weiteren Parameters wird eine weitere Trajektorie anhand einer geeigneten Prozedur erstellt.

Der veränderte Parameter kann eine, aus der ersten Trajektorie und/oder einer weiteren Trajektorie hervorgehende und mittels einer Berechnungsvorschrift der Optimierungsroutine hervorgehende, Zahl oder ein Zahlentupel sein.

Eine Berechnungsvorschrift ist beispielsweise ein genetischer Algorithmus, ein generischer Algorithmus, eine Berechnungsmethode, die auf einem neuronalen Netz basiert, oder auf eine Berechnungsmethode, die auf einer vorgegebenen Zahlenfolge basiert.

Der veränderte Parameter wird vorteilhaft mittels der Optimierungsroutine gemäß einer vorstehend ausgeführten Berechnungsvorschrift ermittelt.

Unter einem extremalen Wert versteht man einen Parameter, der im Vergleich mit einer Anzahl von veränderten Parametern ein Maximum, ein Minimum oder ein Optimum darstellt. Beispielsweise ist ein extremaler Wert eine maximale Geschwindigkeit oder eine maximale Hubzahl oder eine minimal erreichbare Zeitdauer.

Ein vorgegebener Wert ist demnach eine vorgegebene maximale Geschwindigkeit einer Halterung oder eine maximal ausführbare Hubzahl der Produktionsmaschine, vorzugsweise der Presse.

Eine Optimierungsroutine ist eine Berechnungsvorschrift, welche aus einer eingehenden Trajektorie, beispielsweise einer weiteren Trajektorie, eine weitere Trajektorie oder eine optimierte Trajektorie berechnet. Die, mittels der Optimierungsroutine erstellten, weitere Trajektorie wird dem Simulationsprogramm zugeführt. Eine Optimierungsroutine kann auch als Skript, beispielsweise ein Shell-Skript, verfasst sein. So muss ein vorhandenes Simulationsprogramm nicht notwendigerweise verändert werden. Eine Optimierungsroutine kann auch als eigenständiges Programm, als Skript, als Add-on und/oder vorzugsweise als Unterprogramm des Simulationsprogramms, vorliegen.

In einer vorteilhaften Ausgestaltung lädt die Optimierungsroutine von einem Speicher die erste Trajektorie oder die weitere Trajektorie ein. Aus einer ersten Trajektorie wird ein Parameter bestimmt. Aus der weiteren Trajektorie wird ein veränderter Parameter bestimmt. Mittels einer Berechnungsvorschrift wird der Parameter oder der veränderte Parameter verändert. Die Berechnungsvorschrift hat vorteilhaft als Eingangsgrößen die, ggf. in vorherigen Durchläufen bereits erstellten, Trajektorien und/oder die, schon berechneten, (veränderten) Parameter. Mit diesen Eingangsgrößen werden mittels der Berechnungsvorschrift ein (neuer) veränderter Parameter und/oder eine weitere Trajektorie berechnet. Bei der Berechnung eines veränderten Parameters kann aus dem veränderten Parameter die weitere Trajektorie erzeugt werden. Die weitere Trajektorie wird danach entweder abgespeichert und/oder dem Simulationsprogramm zugeführt.

Vorteilhaft werden mit der Optimierungsroutine mehrere weitere Trajektorien erzeugt, wobei entweder eine der weiteren Trajektorien zur Übertragung an das Simulationsprogramm ausgewählt werden oder das Simulationsprogramm eine Simulation für mehrere weitere Trajektorien durchführt und danach die weitere Trajektorie wieder an die Optimierungsroutine überträgt, die sich durch die Simulation am geeignetsten herausgestellt hat. Aus einer Mehrzahl von Trajektorien kann auch eine weitere Trajektorie ausgewählt werden, welche an das Simulationsprogramm übermittelt wird. Weiter können auch die Mehrzahl der Trajektorien mit Hilfe des Simulationsprogramms an die Randbedingungen angepasst werden und im weiteren Verlauf eine Auswahl durchgeführt werden. Ein so ausgestaltetes Verfahren wird beispielsweise bei einem genetischen Algorithmus angewandt. Am besten geeignet ist diejenige der weiteren Trajektorien, welcher der extremale Parameter zugeordnet wird. Vorteilhaft werden nur eine Auswahl der berechneten veränderten Trajektorien, vorzugsweise die veränderten Trajektorie(n) mit den besten veränderten Parameter(n), an das Simulationsprogramm übertragen.

Das Simulationsprogramm simuliert ein Einbringen und/oder eine Entnahme des Bauteils in die Produktionsmaschine. Dabei wird anhand der Randbedingungen geprüft, ob die erste Trajektorie oder die von der Optimierungsroutine erstellte weitere Trajektorie den Randbedingungen genügt. Falls die weitere Trajektorie den Randbedingungen nicht genügt, wird die Trajektorie leicht verändert und/oder an die Optimierungsroutine mit einem entsprechenden Attribut übertragen. Falls die weitere Trajektorie den Randbedingungen genügt, wird sie zur weiteren Veränderung/Optimierung an die Optimierungsroutine übertragen. Falls die optimierte Trajektorie den Randbedingungen genügt, wird diese mit einem Attribut gespeichert und/oder in Form von Koeffizienten und/oder Funktionswerten an die Steuerungseinrichtung übertragen.

Ein Simulationsprogramm kann auch anhand von Randbedingungen eine Bahnkurve für ein Bauteil berechnen, so dass das Bauteil mit einer festgelegten Geschwindigkeit Maschine eingebracht werden kann. Das Simulationsprogramm kann Teil einer Optimierungsroutine sein. Als Randbedingungen dienen hierbei die Form und die Abmessungen des zumindest einen Bauteils, die Form und Abmessungen der Produktionsmaschine, insbesondere der Presswerkzeuge. Die Randbedingungen sorgen für eine kollisionsfreie Bestückung der Produktionsmaschine mit dem zumindest einen Bauteil

Vorteilhaft ist eine solche Berechnungsmethode aufgrund der verbesserten Berechnung einer optimierten Trajektorie. Insbesondere falls mehrere veränderte Trajektorien miteinander verglichen werden, ist erfindungsgemäß eine extremale Trajektorie auffindbar, die selbst ein geübter Fachmann nicht auf manuellem Wege hätte finden können.

Weiter vorteilhaft ist es, dass auch zeitabhängige extremale Trajektorien durch das hier beschriebene Verfahren auffindbar sind.

Zusätzlich ist die benötigte Zeit für die Optimierung einer Trajektorie erheblich geringer.

In einer vorteilhaften Ausgestaltung weist die erste Trajektorie, die weitere Trajektorie und die optimierte Trajektorie als Komponente eine Zeit auf oder ist von der Zeit abhängig.

In diesem Dokument sind die erste Trajektorie, die weitere Trajektorie sowie die optimierte Trajektorie als Trajektorie bezeichnet, falls eine Trajektorie gemeint ist, deren Eigenschaften alle hier aufgeführten Trajektorien teilen.

Eine Trajektorie kann direkt von der Zeit abhängen. Dann ist ein Verlauf des Bauteils direkt von der Zeit abhängig. Dies ist beispielsweise der Fall, falls ein Bauteil eine Trajektorie bei einem Durchlauf in einer unterschiedlichen Zeit durchläuft wie ein Bauteil, welches entlang einer zeitlich nachfolgenden Trajektorie durchlaufen wird. Ebenso kann innerhalb eines Abschnittes der Trajektorie die Zeit, die die Halterung und/oder das Bauteil für diesen Abschnitt der Trajektorie benötigt, verschieden von der Zeit sein, welche die Halterung und/oder das Bauteil für einen gleichlangen, aber verschiedenen Abschnitt der Trajektorie benötigen. So ist es gegebenenfalls notwendig, die Geschwindigkeit des Durchlaufes der Trajektorie in einem Bereich zu verringern, in welcher die Trajektorie stark gekrümmt ist. Die Zeit kann eine absolute Zeit, eine periodisch wiederkehrende Zeitspanne oder eine Eigenzeit der Halterung sein.

Die Trajektorie kann jedoch auch von, ihrerseits zeitabhängigen, Parametern abhängen.

Die formale Darstellung der zeitlichen Abhängigkeit der Trajektorie hängt vorteilhaft von der Ausgestaltung der Optimierungsroutine und/oder vom Simulationsprogramm ab.

Weitere mögliche Ausführungen des Verfahrens zur Berechnung einer optimierten Trajektorie sind nachfolgend ausgeführt.

Die Trajektorie kann auch von, ihrerseits zeitabhängigen, Parametern abhängen.

Die formale Darstellung der zeitlichen Abhängigkeit der Trajektorie hängt vorteilhaft von der Ausgestaltung der Optimierungsroutine und/oder vom Simulationsprogramm ab.

In einer weiteren vorteilhaften Ausgestaltung gehen als Randbedingungen die Größe und Form des Bauteils, die Größe und Form der Produktionsmaschine, die Größe und Form der Halterung und/oder eine Verformung des Bauteils und/oder der Halterung ein.

Randbedingungen dienen dem Simulationsprogramm zur Vermeidung einer Kollision der Halterung und/oder des Bauteils mit der Produktionsmaschine, insbesondere einem der Presswerkzeuge einer Presse. Falls die Produktionsmaschine bewegliche Teile aufweist, welche mit der Halterung und/oder dem Bauteil kollidieren können, sind die Randbedingungen vorteilhaft von der Zeit abhängig. Randbedingungen können auch als Einschränkungen der Bewegungen der Halterung und/oder des Bauteils und/oder der Form der Trajektorie verstanden sein. Durch die Zeitabhängigkeit der Randbedingungen ist der Raum der möglichen Trajektorien vergrößert.

In einer weiteren vorteilhaften Ausgestaltung ist die erste Trajektorie, die weitere Trajektorie und die optimierte Trajektorie eine Funktion des Ortes des Bauteils und/oder der Halterung, der Ausrichtung des Bauteils und/oder der Halterung und/oder der Zeit.

Unter der Ausrichtung der Halterung und/oder des Bauteils wird der (Raum-) Winkel verstanden, welchen das Bauteil und/oder die Halterung zur Vertikalen einnehmen. Der Ort ist der Punkt, an der ein festgelegter Punkt der Halterung und/oder das Bauteil sich im Raum befinden. Die Menge der Raumpunkte, die der festgelegte Teil der Halterung oder das Bauteil durchläuft, kann als Trajektorie definiert werden. Neben dem Ort, der Zeit und der Ausrichtung können noch weitere Abhängigkeiten wie die Durchlaufgeschwindigkeit oder die Beschleunigung des Bauteils und/oder der Halterung in die Beschreibung der Trajektorie eingehen.

Die Trajektorie kann durch eine Mannigfaltigkeit an Punkten in einem Raum oder durch Koeffizienten einer festgelegten Funktion (einer Raumkurve) angegeben sein. Vorteilhaft ist bei der Darstellung von Punkten eine besonders genaue und flexible Beschreibung der Trajektorie möglich. Demgegenüber ist bei einer Darstellung der Trajektorie durch Koeffizienten eine besonders kompakte Darstellung der Trajektorie möglich.

Besonders vorteilhaft werden die Trajektorien in beiden Darstellungen zur Verfügung gestellt. So kann eine große Anzahl an Steuerungseinrichtungen die Trajektorien aufnehmen und weiter verarbeiten, das heißt, zur Steuerung der Bestückung der Produktionsmaschine einsetzen.

In einer weiteren vorteilhaften Ausgestaltung wird die optimierte Trajektorie als Funktionswerten und/oder als Koeffizienten an eine Steuerungseinrichtung übermittelt.

Die Steuerungseinrichtung dient zur Ansteuerung der elektrischen Maschinen, wobei mit Hilfe der elektrischen Maschinen die Produktionsmaschine bestückt, beziehungsweise wieder entleert wird. Eine Steuerungseinrichtung kann beispielsweise eine Motorsteuerung zur Steuerung von mehreren, auf einander abgestimmten, Motoren sein, beispielsweise eine SIMATIC oder eine SINUMEKIK der Firma Siemens AG.

In einer weiteren vorteilhaften Ausgestaltung sind der Parameter und der veränderte Parameter zumindest eine Geschwindigkeit, wobei der extremale Wert eine maximale Geschwindigkeit ist.

Der Parameter oder der veränderte Parameter wird in der Optimierungsroutine aus einer ersten Trajektorie und/oder einer weiteren Trajektorie berechnet. Zunächst wird dafür in der, an die Optimierungsroutine zugewiesenen Trajektorie ein Parameter oder ein veränderter Parameter abgeleitet. Der Parameter wird anschließend verändert. Aus dem veränderten Parameter wird die weitere Trajektorie bestimmt oder berechnet. Der Parameter oder der veränderte Parameter ist ein Maß für den Grad der Optimierung der (weiteren) Trajektorie. Vorteilhaft nähert sich der Parameter einem extremalen Parameter oder einem vorgegebenen Parameter an. Bei Erreichen des extremalen Parameters oder des vorgegebenen Parameter durch den weiteren Parameter ist die Trajektorie, die aus dem extremalen bzw. vorgegebenen Parameter hervorgegangen ist, optimiert.

Ein (veränderter) Parameter kann eine Geschwindigkeit, eine Hubzahl oder ein minimaler Abstand des Bauteils und/oder der Halterung zur Produktionsmaschine sein. Ein extremaler Parameter kann eine maximale Geschwindigkeit sein, so dass die Halterung und/oder das Bauteil die Trajektorie in möglichst kurzer Zeit durchläuft. Der Parameter oder der veränderte Parameter kann auch eine Hubzahl, insbesondere einer Presse, oder einer Durchlaufzahl darstellen.

Bei einer besonders bedienerfreundlichen Ausgestaltung des Computerprogrammpaketes läuft das vorstehend ausgeführte Verfahren nach Wahl zumindest einer Option, insbesondere durch anklicken eines Buttons, selbstständig an.

In einer vorteilhaften Ausgestaltung des Verfahrens wird die Produktionsmaschine und das zumindest eine Bauteil in einem dreidimensionalen virtuellen Raum mit Hilfe einer 3D-Anzeige (VRD) angezeigt.

Eine Anzeige der Produktionsmaschine, insbesondere einer Presse, und dem zumindest einen Bauteil erfolgt durch eine 3D-Anzeige, die zur Darstellung von Vorgängen im virtuellen Raum, insbesondere zur Darstellung virtueller Realität geeignet ist. Zur Anzeige eignet sich ein Human-Machine-Interface (HMI). Technische Ausführung einer solchen 3D-Anzeige ist einem holographischen Darstellungsverfahren oder besonders vorteilhaft eine Vorrichtung zur virtuellen Realität wie eine VR-Anzeigevorrichtung (Virtual Reality HMI). Eine solche VR-Anzeigevorrichtung kann einen Ausrichtungssensor aufweisen, so dass der Benutzer im Raum hin- und hersehen kann und somit den virtuellen Raum durch Sichtfenster vollständig abdecken kann.

So kann der Benutzer vorteilhaft die gesamte Produktionsmaschine und sowie die gesamte Bewegung des Bauteils entlang der Trajektorie betrachten.

Beim Einsatz mehrerer VR-Anzeigevorrichtungen können mehrere Benutzer gleichzeitig die Produktionsmaschine und/oder das Bauteil, insbesondere in seiner Bewegung entlang der optimierten Trajektorie, betrachten. Es ist nicht notwendig dass sich die Benutzer im selben Raum aufhalten müssen.

Durch Internet- oder Intranet-Verbindungen können die Benutzer sich in unterschiedlichen Orten befinden.

Eine vorteilhafte Darstellung ergibt sich durch ein bewegtes Bild, welches die Produktionsmaschine, insbesondere die Presse, und das zumindest eine Bauteil in Ihrer vorgesehenen Bewegung zeigt.

Dabei kann eines der Bauteil entlang der optimierten Trajektorie in eine, für das Bauteil vorgesehene, Position platziert werden.

Zur Veranschaulichung der Bewegung eines Bauteils kann die optimierte Trajektorie als sichtbarer Pfad mit angezeigt werden.

Als VR-Anzeigevorrichtung eignen sich Virtual-Realtity-Brillen, eine Google-Glass (Brille), eine Leinwand, ein Bildschirm (jeweils mit der Möglichkeit der 3D-Darstellung) und/oder ein Head-Mounted-Display.

Durch die Darstellung im 3D-Raum kann der Benutzer vorteilhaft eine schnelle und intuitive Vorstellung der Bewegungszusammenhänge der Produktionsmaschine, insbesondere dessen einzelnen Werkzeugen, und dem zumindest einen Bauteil bekommen. Probleme im Bewegungsabläufe und Verbesserungsmöglichkeiten sind so einfach und intuitiv erfassbar.

In einer weiteren vorteilhaften Ausgestaltung zumindest das Bauteil entlang der optimierten Trajektorie bewegt angezeigt.

Die Anzeige der optimierten Trajektorie des sich bewegenden Bauteils, kann beispielsweise durch eine durchgezogene Linie erfolgen, auf der sich das Bauteil bewegt. Falls das Bauteil sich, gemäß der optimierten Trajektorie, orthogonal zur Bewegungsrichtung dreht, so ist auch eine Darstellung der optimieren Trajektorie als verbreiterte Linie, etwa als Band, möglich. Das Band kann durch eine Änderung der Orientierung der Oberfläche die Drehung verdeutlichen.

Vorteilhaft ist durch die Darstellung der optimierten Trajektorie der Benutzer in der Lage, zu erkennen, in welchen Bereichen eine weitere Optimierung der Bewegungsabläufe der Produktionsmaschine und/oder der Bestückung derselben mit zumindest einem Bauteil möglich und/oder geboten scheint.

In einer weiteren vorteilhaften Ausgestaltung wird eine Nichteinhaltung von Randbedingungen bei der Bewegung des Bauteils mit der Produktionsmaschine angezeigt.

Hierbei kann die Kollision durch eine geänderte farbliche Markierung des Bauteils oder eines Bereiches der Produktionsmaschine dargestellt werden. Vorteilhaft wird für die Darstellung der Kollision eine leuchtende Farbmarkierung verwendet, die sich auffallend von der weiteren Darstellung abhebt und somit von dem Benutzer oder den Benutzern nicht übersehen werden kann.

Der Benutzer kann durch ein zeitnahes Anzeigen einer Kollision des Bauteils, insbesondere mit der Produktionsmaschine, erkennen, ob die optimierte Trajektorie für das Bauteil die Randbedingungen in Bezug auf die Kollision erfüllt. Somit kann auch geprüft werden, welche Auswirkungen eine Veränderung einer Randbedingung und/oder eine Veränderung der optimierten Trajektorie hat.

In einer weiteren Ausgestaltung des Verfahrens kann zumindest ein Benutzer mit Hilfe einer Darstellungsvorrichtung die Bewegung des Bauteils in die Produktionsmaschine hinein oder heraus betrachten.

Die Bewegung des zumindest einen Bauteils kann durch mehrere Benutzer gleichzeitig betrachtet werden. Die gleichzeitige Betrachtung eines Bewegungsablaufs kann von unterschiedlichen Positionen bzw. Blickrichtungen der einzelnen Benutzer erfolgen. So kann ein erster Benutzer das Bauteil von einer Seite betrachten und ein zweiter Benutzer das gleiche Bauteil von einer anderen Seite oder von einer anderen Position aus betrachten.

Vorteilhaft können die Benutzer das Verhalten der Produktionsmaschine und das Bauteil in Bewegung betrachten und optional beurteilen.

Die Ablaufgeschwindigkeit kann von einem jeden Benutzer unabhängig gewählt werden. So kann auf die individuellen Bedürfnisse eines jeden Benutzers gesondert eingegangen werden.

In einer weiteren vorteilhaften Ausgestaltung des Verfahrens wird die Nichteinhaltung der Randbedingungen bei der Bewegung des Bauteils mit der Produktionsmaschine angezeigt.

Es ist weiter vorteilhaft, dass die Randbedingungen, beispielsweise in Form eines Baltendiagramms, dem Benutzer angezeigt werden. Die Anzeige kann in einem Sichtfenster angezeigt sein. Randbedingungen, die sich zur Anzeige besonders eignen sind: die Motorleistung eines Antriebs der Produktionsmaschine, Geschwindigkeiten von Werkzeugen und/oder einem der Bauteile, Haltekräfte.

Bei einer weiteren vorteilhaften Ausgestaltung des Verfahrens verändert zumindest ein Benutzer mit Hilfe zumindest einer VR-Eingabevorrichtung die optimierte Trajektorie, wobei durch die Veränderung der optimierten Trajektorie die optimierte Trajektorie in eine erste Trajektorie umgewandelt wird, wobei die erste Trajektorie mit dem Verfahren zur Berechnung einer optimierten Trajektorie gemäß den vorstehenden Ausführungen wieder optimiert und angezeigt wird.

Eine Veränderung einer optimierten Trajektorie erfolgt beispielsweise mit einem Cursor, der mit Hilfe der VR-Eingabevorrichtung einen Punkt oder einen Bereich der optimierten Trajektorie auswählt. Mittels einer Bewegung des Cursors kann der Punkt oder der Bereich der optimierten Trajektorie verändert werden. Die Veränderung kann dem Benutzer angezeigt werden.

Als VR-Eingabevorrichtung eignet sich ein Joystick, eine 3D-Maus mit einem 3D-Bewegungssensor oder ein Datenhandschuh. Weiter kann eine Eingabe durch Sprachsteuerung erfolgen. Als besonders vorteilhaft für die Erfindung hat sich die Verwendung eines Joysticks, oder mehrerer Joysticks herausgestellt. Daher wird im Folgenden VR-Eingabevorrichtung und Joystick synonym verwendet.

Mittels des Cursors wird ein Bereich oder ein Punkt der Trajektorie ausgewählt und anschließend durch den Benutzer verschoben.

Die punktweise oder bereichsweise verschobene optimierte Trajektorie bildet eine erste Trajektorie in dem Verfahren zur Berechnung einer optimierten Trajektorie, welche unter Berücksichtigung der Randbedingungen mit Hilfe der Optimierungsroutine wieder zu einer optimierten Trajektorie optimiert wird.

Vorteilhaft ist durch ein solches Vorgehen eine Beeinflussung des Verfahrens zur Bereitstellung einer optimierten Trajektorie durch einen intuitiv erfassenden und denkenden Benutzer möglich. Ein erfahrener Benutzer kann somit einen Impuls in eine Richtung der Optimierung geben, welche das Verfahren zur Bereitstellung der optimierten Trajektorie verbessert.

Gleichzeitig kann der Benutzer seine Intuition dafür stärken, wie sich eine punktweise/bereichsweise Veränderung einer optimierten Trajektorie auf den Verlauf der optimierten Trajektorie aufweist.

Ein Anzeigen einer Kollision des Bauteils mit der Produktionsmaschine durch farbliche Markierungen der Bereiche der Produktionsmaschine und/oder (des Teils) des Bauteils stärkt vorteilhaft die Intuition des Benutzers für die hier beschriebenen Vorgänge.

Vorteilhaft kann sich durch einen Einbezug des Benutzers oder mehrerer Benutzer eine Verbesserung des Verfahrens zur Berechnung des optimierten Verfahrens ergeben. Der Benutzer erkennt möglicherweise ein lediglich lokales Minimum bei der Optimierung der Trajektorie und kann durch manuelles Eingreifen die Berechnung der optimierten Trajektorie verbessern. Weist das Simulationsprogramm und/oder die Optimierungsroutine einen selbstlernen Anteil, z. B. ein neuronales Netz, auf, so kann durch dieses Wechselspiel das Verfahren insgesamt verbessert/trainiert werden.

In einer weiteren vorteilhaften Ausgestaltung werden die zumindest die Produktionsmaschine und das zumindest eine Bauteil transparent angezeigt.

Eine transparente oder teilweise durchsichtige Darstellung des Bauteils und/oder der Produktionsmaschine kann durch eine Anzeige der Ränder und/oder Ecken durch Linie, insbesondere in perspektivischer Darstellung, erfolgen. Flächen können unterschiedlich transparent dargestellt werden. Eine Linie (Kante) wird dabei nicht transparent dargestellt.

Durch eine, zumindest teilweise, transparente Produktionsmaschine und/oder ein, zumindest teilweise, angezeigtes Bauteil kann der zumindest eine Benutzer durch die Produktionsmaschine und/oder durch das Bauteil hindurch sehen. Somit kann der Benutzer / können die Benutzer auch die Vorgänge sehen, die hinter bzw. unter dem Bauteil und/oder der Produktionsmaschine verborgen sind.

In einer vorteilhaften Ausgestaltung des Verfahrens kann die Ansicht auf die Produktionsmaschine und/oder das Bauteil von mehreren Punkten und/oder von mehreren Ausrichtungen aus angezeigt werden, wobei der Benutzer den Punkt und/oder die Ausrichtung wählen kann.

Die Darstellung von unterschiedlichen Punkten aus schließt auch Ansichten aus dem Inneren des Bauteils und/oder aus dem Inneren der Produktionsmaschine ein. Durch die Anzeige der Bewegungsvorgänge von mehreren Punkten aus kann der Benutzer oder die Benutzer die Bewegung aus einer Perspektive betrachten, welche in einem wirklichen, realen Model der Produktionsmaschine nicht möglich ist.

Somit ist die Darstellung gemäß zumindest einem Aspekt der Erfindung sehr gut zur Einarbeitung des Benutzers geeignet, der später die Produktionsmaschine bedienen soll.

Eine Veränderung der Ausrichtung des Sichtfensters für den Benutzer erfolgt vorteilhaft durch die Ausrichtung des Kopfes des Benutzers. Eine Veränderung des Punktes, von dem das Sichtfenster ausgeht, ist vorteilhaft durch die VR-Eingabevorrichtung oder durch Spracheingabe möglich.

In einer weiteren vorteilhaften Ausgestaltung werden die Produktionsmaschine und/oder das zumindest eine Bauteil zumindest zwei Benutzern angezeigt, wobei eine Nichtbeachtung der Randbedingungen, insbesondere einer Kollision des Bauteils mit der Produktionsmaschine, zumindest einem der Benutzer angezeigt wird.

Die gleichzeitige Anzeige einer Kollision des zumindest einen Bauteils mit der Produktionsmaschine für mehrere Benutzer erfolgt zum Beispiel mit Hilfe mehreren VR-Anzeigevorrichtungen, insbesondere eine VR-Brillen.

Bei mehreren Benutzern ist eine unterschiedliche Geschwindigkeit der angezeigten Bewegungsabläufe möglich. Der erste Benutzer kann eine Anzeigegeschwindigkeit, d. i. die Geschwindigkeit der Bewegungsabläufe der Produktionsmaschine und/oder der Geschwindigkeit des Bauteils entlang der (optimierten) Trajektorie, die von der Anzeigegeschwindigkeit des zweiten Benutzers verschieden ist.

Durch ein gleichzeitiges Anzeigen des hier beschriebenen Bewegungsablaufes zu mehreren Benutzern können sich austauschen. Ein solcher Austausch kann vorteilhaft der Ausbildung einer der Benutzer dienen.

Das Verfahren wird vorteilhaft durch eine Recheneinheit, insbesondere einem Personal-Computer, durchgeführt. Die Recheneinheit weist hierbei eine 3D-Anzeige auf oder zumindest eine Anschlussmöglichkeit für eine 3D-Anzeige. Besonders vorteilhaft weist die Recheneinheit zumindest eine VR-Anzeigevorrichtung und optional zumindest eine VR-Eingabevorrichtung auf zumindest Anschlüsse hierfür. Das Verfahren wird durchgeführt, indem das Computerprogramprodukt in einen Speicher der Recheneinheit geladen wird und mit Hilfe einer CPU (Central Processor Unit) ausgeführt wird. Das Computerprogramm weist vorteilhaft folgende Teile auf:
- Eine Datei, in der die Position, Größe und Form der Produktionsmaschine und des zumindest einen Bauteils vorgegeben wird. Optional kann die Datei auch die Trajektorien und die Randbedingung sowie die Bewegungsabläufe aufweisen.
- Eine Optimierungsroutine, insbesondere ein sogenannter Solver.
- Ein Interface, wobei das Interface zur Darstellung der Bewegungsabläufe mit Hilfe der Hardware der Recheneinheit bereitstellt. Das Interface dient zur Darstellung der ermittelten Bewegungsabläufe mit Hilfe der 3D-Anzeige.

Das Computerprogrammpaket dient vorteilhaft zur Durchführung des vorstehend ausgeführten Verfahrens, wobei das Simulationsprogramm zumindest als Teil des Computerprogrammpakets oft schon besteht. Die Optimierungsroutine kann vorteilhaft in das Simulationsprogramm integriert werden. Auf der Bedienungsoberfläche (Human-Machine-Interface) des Simulationsprogramms ist das vorstehend ausgeführte Verfahren vorteilhaft als Menüpunkt auswählbar. Bei Einbeziehung einer solchen Einbindung der Optimierungsroutine kann der Start mittels eines Knopfes (Buttons) generiert sein. Beispielsweise wird bei Anklicken eines solchen Buttons das Verfahren gestartet und läuft so lange ab, bis die Trajektorie eine optimierte Trajektorie geworden ist. Anschließend wird die optimierte Trajektorie in den vorstehend ausgeführten Formen an die Steuerungseinheit übertragen.

Im Folgenden wird die Erfindung anhand der in den Figuren dargestellten Ausführungsbeispiele näher beschrieben und erläutert. Es zeigen:
- FIG 1: eine Produktionsmaschine, ein Bauteil und eine Trajektorie,
- FIG 2: ein Schema zur Berechnung einer optimierten Trajektorie,
- FIG 3: den Einfluss eines Benutzers auf das Verfahren zur Bereitstellung einer optimierten Trajektorie,
- FIG 4: den Einfluss eines ersten Benutzers und eines zweiten Benutzers,
- FIG 5: eine mögliche Darstellung für einem Benutzer sowie
- FIG 6: eine mögliche Darstellung für zwei Benutzer.

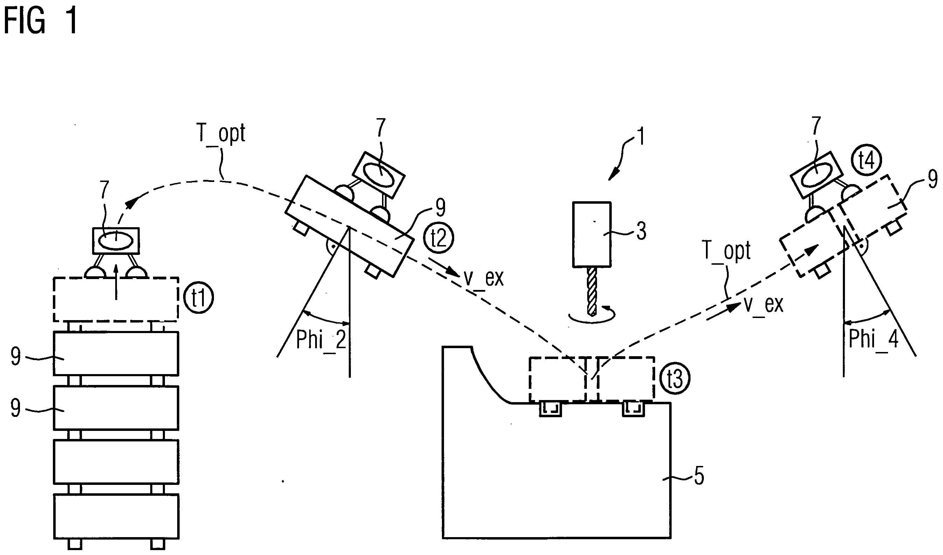

FIG 1 zeigt eine Produktionsmaschine 1, ein Bauteil 9 und eine Trajektorie T_opt. Zum Zeitpunkt t1 werden Bauteile 9 von der Halterung 7 aufgenommen und entlang der Trajektorie T_opt in die Produktionsmaschine 1 befördert. Das Bauteil 9 und die Halterung 7 verlaufen dabei entlang der Trajektorie T_opt. Zum Zeitpunkt t2 wird das Bauteil 9 mit Hilfe der Halterung in seiner Ausrichtung Phi_2 ausgerichtet. Zum Zeitpunkt t2 weist das Bauteil 9 und die Halterung 7 eine Geschwindigkeit v auf. Die Geschwindigkeit ist vorteilhaft eine Funktion der Zeit t und/oder der Position beziehungsweise der Ausrichtung Phi des Bauteils. Das Bauteil 9 wird von der Halterung 7 in die Produktionsmaschine 1, insbesondere in das untere Werkzeug 5 der Produktionsmaschine 1 eingelegt. In der Produktionsmaschine 1 wird das Bauteil 9 mit dem oberen Werkzeug 3 bearbeitet. Also oberes Werkzeug 3 dient hier ein Bohrer 3 oder ein Teil einer Fräsmaschine 3. Nach der Bearbeitung in der Produktionsmaschine 1 nimmt die Halterung 7 zum Zeitpunkt t3 das Bauteil 9 wieder auf und führt es entlang einer optimierten Trajektorie T_opt aus der Produktionsmaschine 1 heraus. Zum Zeitpunkt t4 ist das Bauteil 9 auf dem Weg zu einer neuen Station. Zu jedem Zeitpunkt t1, t2, t3, t4 weist das Bauteil eine Geschwindigkeit v auf. Zum Zeitpunkt t2 weist das Bauteil 9 und die Halterung 7 eine Ausrichtung Phi_2 auf. Zum Zeitpunkt t4 weist das Bauteil 9 und die Halterung 7 eine Ausrichtung Phi_4 auf. Die Geschwindigkeit v stellt dabei einen Parameter v, v' dar, welcher die Schnelligkeit der Produktion maßgeblich beeinflusst. Die Ausrichtung des Werkstückes 9 und/oder der Halterung 7 zu jedem Zeitpunkt ist durch die Ausrichtung Phi vorgegeben.

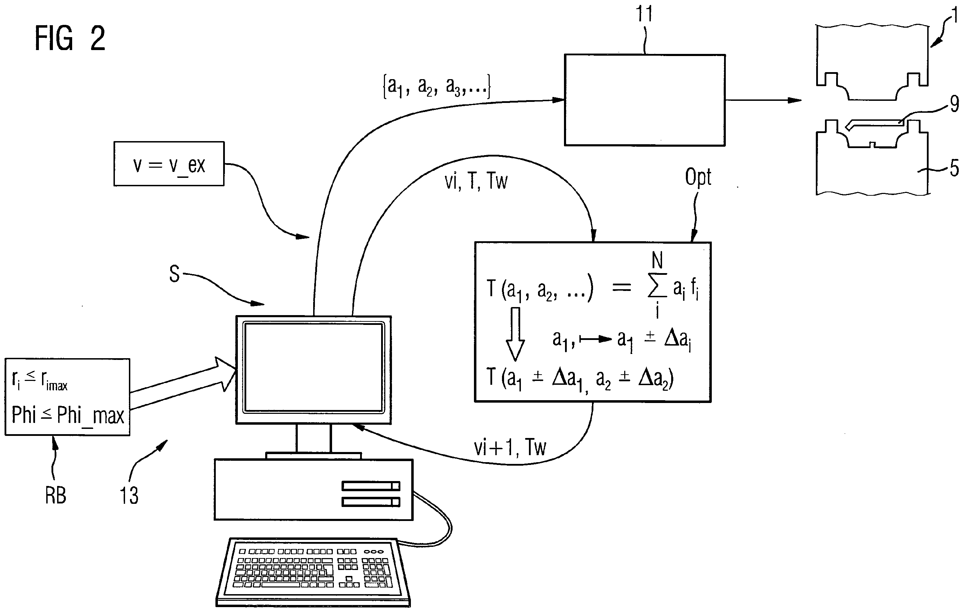

FIG 2 zeigt ein Schema zur Berechnung einer optimierten Trajektorie T_opt. Gezeigt ist eine Recheneinheit 13, beispielsweise ein Personal Computer 13, auf dem das Simulationsprogramm S installiert ist und abläuft. Die Berechnung der optimierten Trajektorie T_opt erfolgt mit Hilfe des Simulationsprogramms S und/oder der Optimierungsroutine Opt. Weiter ist auch die Optimierungsroutine Opt auf der Recheneinheit 13 installiert. Obgleich die Optimierungsroutine Opt Teil des Simulationsprogramm S sein kann, ist die Optimierungsroutine Opt getrennt von dem Simulationsprogramm S dargestellt. Das Verfahren startet mit Vorgabe einer ersten Trajektorie T1, beispielsweise händisch durch einen Benutzer. Die erste Trajektorie T1 kann auch durch Vorgaben des Benutzers mit dem Simulationsprogramm S erstellt worden sein. Weiter sind Randbedingungen RB vorgegeben, wobei auch die Randbedingungen RB vorteilhaft aus CAD-Zeichnungen der Produktionsmaschine 1, des zumindest einen Bauteils 9 sowie gegebenenfalls weiterer Größen mittels des Simulationsprogramms S ermittelt worden sein können. Bei einem ersten Durchlauf des Verfahrens erfolgt die Ermittlung eines Parameters v, hier vorteilhaft durch das Simulationsprogramm S. Es ist auch möglich, den Parameter v mit Hilfe der Optimierungsroutine Opt zu bestimmen. Nach Berechnung der (ersten) Trajektorie T1 wird die (erste) Trajektorie T1 und gegebenenfalls der Parameter v oder der weiteren Parameter vi an die Optimierungsroutine Opt übermittelt. In der Optimierungsroutine Opt wird in einer vorteilhaften Weise eine Darstellung der Trajektorie T(a1, a2, ...) bereitgestellt, beispielsweise einer Reihendarstellung. Die Koeffizienten aᵢ, i=1,...,N der Reihendarstellung der Trajektorie T(a₁,a₂,...) werden in einem weiteren Schritt gemäß einem deterministischen oder propabilistischen Schema verändert. Beispielsweise werden die einzelnen Koeffizienten a₁ vergrößert aᵢ+Δaᵢ oder verkleinert aᵢ-Δaᵢ. Aus den so veränderten Koeffizienten aᵢ±Δaᵢ wird eine veränderte Trajektorie T(a₁±Δa₁, a₂±Δa₂,...) erstellt. Vorteilhaft wird die veränderte Trajektorie T(a₁±Δa₁, a₂±Δa₂,...) wieder auf die erste Trajektorie T(a₁,a₂,...) normiert.

Die veränderte Trajektorie Tw = T(a₁±Δa₁, a₂±Δa₂,...) wird dann an das Simulationsprogramm S übertragen. Das Simulationsprogramm richtet die veränderte/weitere Trajektorie Tw so, dass die Randbedingungen RB eingehalten werden. Vorteilhaft ist das Simulationsprogramm S in der Lage, die weitere Trajektorie Tw anhand ihrer neuen Eigenschaften mit der vorangehenden Trajektorie T zu vergleichen. Als Vergleichsmaßstab dient beispielsweise der Parameter vi, vi+1, v, v'. Ist der Parameter vi, vi+1, v, v' beispielsweise die Geschwindigkeit vi, vi+1, v, v', mit der das Bauteil 9 in die Produktionsmaschine 1 eingeführt und/oder wieder entnommen ist, so ist die Veränderung der Trajektorie T, Tw als ein Schritt in die richtige Richtung, hin zur Form der optimierten Trajektorie T_opt zu werten.

Die vorstehend beschriebene Schleife wird so lange durchlaufen, bis die Änderungen Δai des veränderten Parameters vi, vi+1 nach Durchlauf der Schleifen unter einen vorgegebenen Wert fallen oder sobald der veränderte Parameter einen vorgegebenen Bereich unterschreitet. Die Trajektorie T und die weitere Trajektorie kann zwischen dem Simulationsprogramm S und der Optimierungsroutine Opt in Form von Parametern v, v+1, als Trajektorien T, Tw und/oder in der Form von Koeffizienten a1, a2,... übertragen werden.

Die im letzten Durchlauf der Schleife erhaltene optimierte Trajektorie T_opt wird bei Erreichen des extremalen Parameters v_ex in Form von Koeffizienten a₁,a₂,... an die Steuerungseinrichtung 11 übermittelt. Die Steuerungseinrichtung 11 steuert die Bestückung der Produktionsmaschine 1 mit Bauteilen, insbesondere durch die Steuerung 11 der durchlaufenen optimierten Trajektorie T_opt der Halterung 7 für das Bauteil 9.

Zur Berechnung oder Bereitstellung der optimierten Trajektorie, wie in FIG 1 und FIG2 gezeigt, ist weiter folgendes anzumerken.

Insbesondere ist in FIG 2 ein Schema des ersten Durchganges der Schleife zur Berechnung der optimierten Trajektorie T1 offenbart. Ausgehend von einer ersten Trajektorie T1 wird mit Hilfe des Simulationsprogrammes S sichergestellt, ob die erste Trajektorie T1 die Randbedingungen RB erfüllt. Falls die Randbedingungen RB durch die erste Trajektorie T1 nicht erfüllt sind, wird die erste Trajektorie T1 mit Hilfe des Simulationsprogramms S angepasst. Die erste Trajektorie T1 wird dann an die Optimierungsroutine Opt übermittelt. Mit Hilfe der Optimierungsroutine wird ein Parameter v aus der ersten Trajektorie T1 (und/oder einer weiteren Trajektorie Tw) ermittelt. Der Parameter v wird mit Hilfe der Optimierungsroutine Opt in einen veränderten Parameter v' verändert. Mit Hilfe des veränderten Parameters v' wird eine weitere Trajektorie Tw erzeugt. Die weitere Trajektorie Tw wird an das Simulationsprogramm S übertragen. Mit Hilfe des Simulationsprograms S wird die weitere Trajektorie an die Randbedingungen RB angepasst. Nach erfolgter Anpassung der weiteren Trajektorie Tw wird diese wieder an die Optimierungsroutine übertragen wobei mit der Optimierungsroutine Opt in der weiteren Trajektorie Tw ein Parameter v erzeugt. Der Parameter v wird mit Hilfe der Optimierungsroutine Opt in einen veränderten Parameter v' überführt. Mit Hilfe zumindest des veränderten Parameters v' wird eine weitere Trajektorie Tw erstellt.

Bei der Erstellung der weiteren Trajektorie Tw und/oder des veränderten Parameters v' können auch (veränderte) Parameter v, v' und/oder schon erzeugte und gegebenenfalls gespeicherte (weitere) Trajektorien T1, Tw berücksichtigt werden.

Sobald der veränderte Parameter v' einen bestimmten Wert v_ex oder bestimmte Werte v_ex erreicht habt, so kann wird aus der weiteren Trajektorie Tw die optimierte Trajektorie T_opt. Diese wird gegebenenfalls noch einmal an den Randbedingungen RB überprüft. Die optimierte Trajektorie wird dann für die Steuerungseinrichtung 11 Produktionsmaschine 1 bereitgestellt.

Das vorgestellte Verfahren ist insbesondere zur Durchführung einer Simulation für Pressen, beispielsweise der Software "Press Line Simulation" der Firma Siemens AG, vorteilhaft einsetzbar.

Mittels des Simulationsprogramms erfolgt dabei eine Darstellung eines Simulationsszenarios. Beispiele für ein Simulationsszenario ist die Einrichtung einer Presse 1 oder einer Produktionsmaschine 1 oder einer Kollisionsanalyse. Die Veränderung der Parameter v, v' erfolgt vorteilhaft unter Berücksichtigung einer Transferkurve (Trajektorie T, weitere Trajektorie Tw, oder optimierte Trajektorie T_opt).

Resultate eines hier vorgestellten Verfahrens sind beispielsweise ein Kollisionsbericht, eine Stückliste der mit der Halterung 7 zu transportierenden Bauteile 9, eine Liste der Programmierwerte und/oder ein Simulationsvideo bzw. eine Bildabfolge.

Das Verfahren zur Berechnung einer optimierten Trajektorie erfolgt vorteilhaft in zwei Schritten:
- Zum einen eine Änderung von Größen wie die Trajektorie T, Tw, T_opt, bis keine Kollision des Bauteils 9 und/oder der Halterung mehr mit einem weiteren Element, insbesondere der Produktionsmaschine 1 und/oder der Presse 1 mehr auftritt.
- Zum anderen in einer Optimierung der Geschwindigkeit v, v', v_ex des Bauteils 9 entlang einer solchen Trajektorie T, Tw, insbesondere einer optimierten Trajektorie T_opt und/oder einer Optimierung der Hubzahl v, v', v_ex einer Presse 1 oder der Produktionsmaschine 1.

Als Basis eines Optimierungsverfahrens dient vorteilhaft ein so genannter Solver. Ein Solver ist vorzugsweise eine OpenSource Software, die einen allgemeinen Optimierungsalgorithmus enthält und für den jeweiligen Fall angepasst werden kann. Eine solche Anpassung erfolgt vorteilhaft in Angabe von Parameter aller Art, Werten, die den Solver beeinflussen, sowie durch Hinzufügen von eigenen Programmcodes zu dieser Solver-Software. Ein Hinzufügen kann auch in einem so genannten Software-Add-On erfolgen.

Trajektorien T, T1, Tw, T_opt werden oft auch als Transferkurven oder Transportkurven bezeichnet. Diese werden während der Simulation mit Hilfe des Simulationsprogramms S laufend angepasst, ggf. mit Hilfe einer hier vorgestellten Optimierungsroutine Opt, bis ein Optimum erreicht ist. Vorteilhaft kann ein hier beschriebenes Verfahren nach Errichtung der Produktionsanlage, die eine Produktionsmaschine 1 aufweist, erfolgen. Im Betrieb der Produktionsanlage erfolgt danach nur noch ein leichtes Abstimmen der optimierten Trajektorie.

Vorteilhafte Größen für die Parameter bzw. für die Randbedingungen sind einzuhaltende Abstandswerte zwischen Bauteil 9 / Halterung 7 und den weiteren Elementen (wie der Produktionsmaschine 1). Weitere Parameter orientieren sich auch vorteilhaft an der Ausrichtung (Drehwerte) des Bauteils 9, Anfangszeitpunkte ti, t und/oder Endzeitpunkte ti, t des Bauteils 9 und/oder der Halterung 7 während des Durchlaufs entlang der (optimierten) Trajektorie T, Tw, T_opt.

Vorteilhaft findet auch eine Variation der Anzahl der so genannten Stützpunkte der (optimierten) Trajektorie T, T_opt, Tw statt. Stützpunkte sind Raumpunkte, die die (optimierte) Trajektorie T, T1, Tw, T_opt definieren/aufspannen.

In den folgenden Figuren bedeuten schraffierte Pfeile, eine Möglichkeit der direkten Beeinflussung des Benutzers B, B1, B2 mit der dargestellten Produktionsmaschine 1, dem dargestellten Bauteils 9 und/oder mit der dargestellten optimierten Trajektorie T_opt. Die Beeinflussung kann durch einen Cursor, analog einer Bedienung des Betriebssystems MS Windows erfolgen.

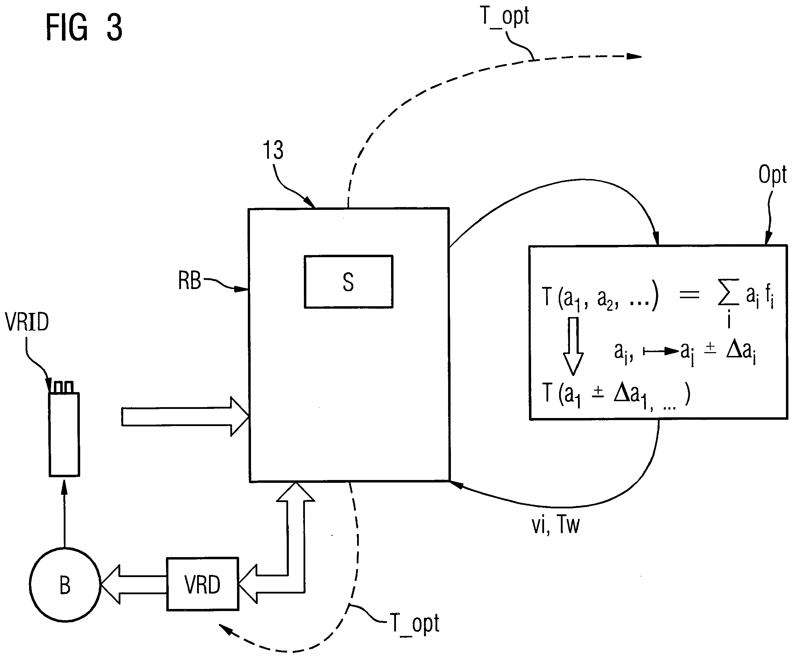

FIG 3 zeigt den Einfluss eines Benutzers B1, B2 auf das Verfahren zur Bereitstellung einer optimierten Trajektorie T_opt. Mittig gezeigt ist die Recheneinheit 13, beispielswiese durch einen Computer 13 ausgeführt. Auf der Recheneinheit ist das Simulationsprogramm S installiert. Das Simulationsprogramm S dient zur Durchführung des Verfahrens zur Bereitstellung einer optimierten Trajektorie T_opt. Die optimierte Trajektorie wird, wie auch in FIG 2 dargestellt, durch ein Zusammenspiel der Optimierungsroutine Opt und dem Simulationsprogram S berechnet. Die Optimierungsroutine Opt kann auch in dem Simulationsprogramm S integriert sein.

Eingangsgrößen des Simulationsprogramm sind die Randbedingungen RB sowie ggf. eine erste Trajektorie T1. Das Simulationsprogramm S stellt die optimierte Trajektorie der 3D-Anzeige VRD, insbesondere einer VR-Anzeigevorrichtung VRD zur Verfügung. Die virtuelle 3D-Anzeige VRD kann eine Virtuelle Realitätsbrille VRD (virtual reality Brille, head-mounted display) oder einem 3D-Bildschirm /3D-fähiger Projektor mit entsprechender Leinwand ausgeführt sein. Die 3D-Anzeige VRD zeigt dem Benutzer B das Bauteil 1, insbesondere die vorgesehene Bewegung des Bauteils 1. Dem Benutzer B wird vorteilhaft auch die Produktionsmaschine 1, und optional die optimierte Trajektorie T_opt, angezeigt. Vorteilhaft wird das Bauteil 9 entlang der optimierten Trajektorie T_opt bewegend angezeigt. Weiter vorteilhaft wird dem Benutzer die Produktionsmaschine 1 im bewegten Zustand angezeigt. Die optimierte Trajektorie T_opt gibt die Bewegung des Bauteils 1 an. Der Benutzer B kann mit Hilfe einer VR-Eingabevorrichtung VRID, beispielsweise eines Joysticks VRID, eines Datenhandschuhes oder ähnlichem den Verlauf der optimierten Trajektorie T_opt beeinflussen.

Als VR-Eingabevorrichtung eignet sich auch eine Sprachsteuerung, eine Gestensteuerung oder dergleichen.

Falls der Benutzer B die optimierte Trajektorie T_opt zumindest bereichsweise verändert, optimiert das Simulationsprogramm S die (bereichswese veränderte) optimierte Trajektorie T_opt wieder. Das Verfahren zur Berechnung der optimierten Trajektorie T_opt läuft dabei widerholt auf der Recheneinheit und dem Simulationsprogramm ab. Der Ablauf der Optimierung der Trajektorie T_opt verläuft dergestalt, dass die angezeigte optimierte Trajektorie T_opt für das Bauteil 1 wieder die Randbedingunen erfüllt. Bis die optimierte (zumindest bereichsweise veränderte) optimierte Trajektorie T_opt die Randbedingungen RB (noch) nicht erfüllt, kann dies durch eines Darstellung, insbesondere durch farbliches Hervorheben, der Kollisionsstellen zwischen dem Bauteil 9 und der Produktionsmaschine 1 angezeigt werden.

Das Simulationsprogramm behandelt die (zumindest bereichsweise) veränderte optimierte Trajektorie T_opt wieder wie eine erste Trajektorie T1. Mit Hilfe des erfindungsgemäßen Verfahrens wird eine neue optimierte Trajektorie T_opt berechnen. Optimal kann die optimierte Trajektorie T_opt aus dem Simulationsprogramm S auf weitergeleitet werden und/oder auf einen Datenträger gespeichert werden.

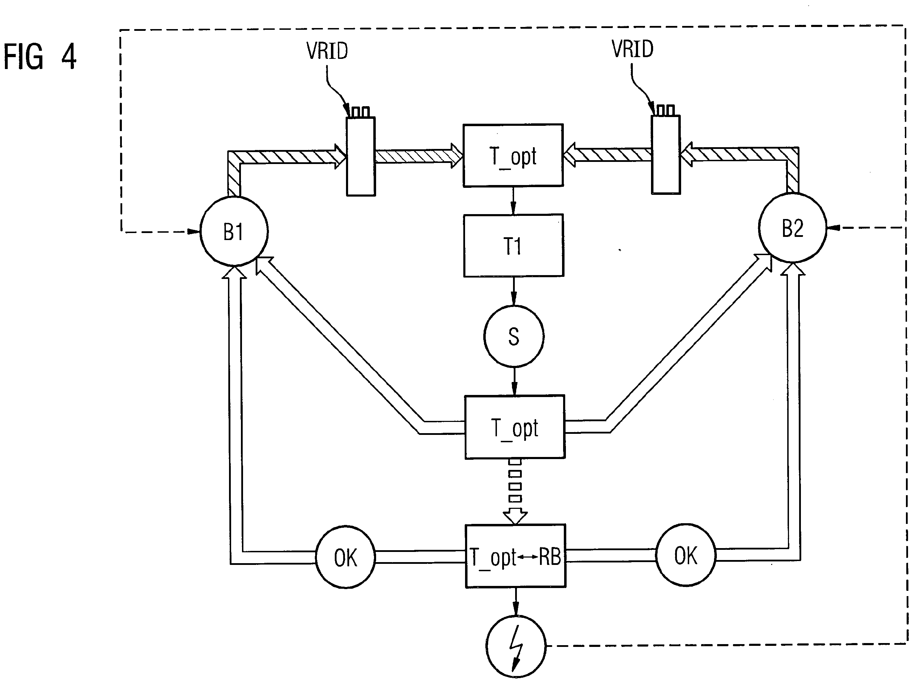

FIG 4 zeigt den Einfluss eines ersten Benutzers B1 und eines zweiten Benutzers B2. Ausgehend von einer optimierten Trajektorie T_opt, die durch einen ersten Benutzer B1 und/oder einen zweiten Benutzer B2 verändert worden ist, wird die optimierte Trajektorie T_opt wie oben angedeutet, wieder zu einer ersten Trajektorie T1 oder als eine solche behandelt. Mit Hilfe des Simulationsprogramms S wird die erste Trajektorie T1 zur optimierten Trajektorie T_opt gewandelt. Die (neu berechnete) optimierte Trajektorie T_opt wird dem ersten Benutzer B1 und/oder den zweiten Benutzer B2 in der 3D-Anzeige (VRID) dargestellt. In einem weiteren Schritt wird ermittelt, ob die optimierte Trajektorie die (ggf. veränderten) Randbedingungen RB erfüllt. Sollte dies nicht der Fall sein, beispielsweise durch einen unzureichenden Optimierungsgrad der optimierten Trajektorie T_opt, kann eine mögliche Kollision dem Benutzer B1, B2 angezeigt werden. Sollte die die optimierte Trajektorie T_opt die Randbedingungen RB erfüllen, so wird dies ebenfalls vorteilhaft dem ersten Benutzer B1 und/oder dem zweiten Benutzer B2 angezeigt. Die Benutzer B1, B2 können ihrerseits die optimierte Trajektorie mit Hilfe der VR-Eingabevorrichtung VRID (Virtual Reality Input Device) verändern. Danach kann das hier gezeigte Verfahren von Neuem ablaufen.

Im Falle eines unzureichenden Grades der Optimierung der optimierten Trajektorie T_opt, das heißt, dass die Randbedingungen RB, insbesondere in Bezug auf mögliche Kollisionen des Bauteils 9 mit der Produktionsmaschine 1, wird dies dem ersten Benutzer B1 und/oder dem zweiten Benutzer B2 die Nichterfüllung der Randbedingungen RB angezeigt. Diese Anzeige kann durch eine farbliche Kennzeichnung der Stelle bzw. Bereichs der möglichen Kollision des Bauteils 9 mit der Produktionsmaschine 1 erfolgen.

Da eine Nichterfüllung der Randbedingungen RB der optimierten Trajektorie T_opt die Ausnahme sein sollte, ist diese Anzeige nur gestrichelt in der FIG 4 gezeigt. Der Pfad "OK" wird gewählt, wenn die optimierte Trajektorie T_opt nach Durchlauf des Verfahrens zur Berechnung der optimierten Trajektorie T_opt durch das Simulationsprogramm S erfolgt ist und die Randbedingungen RB erfüllt sind.

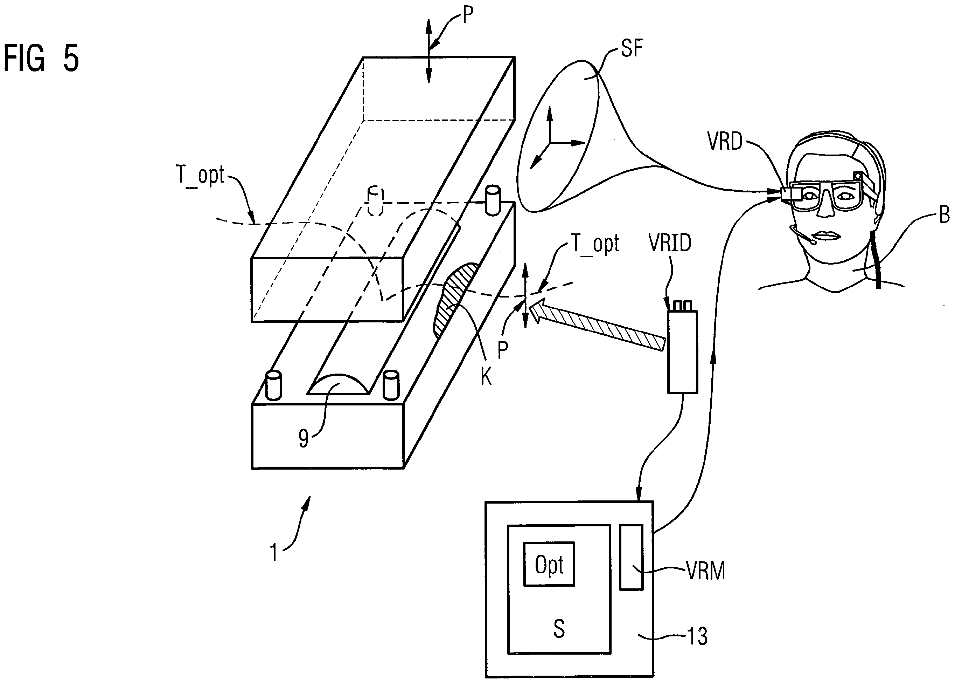

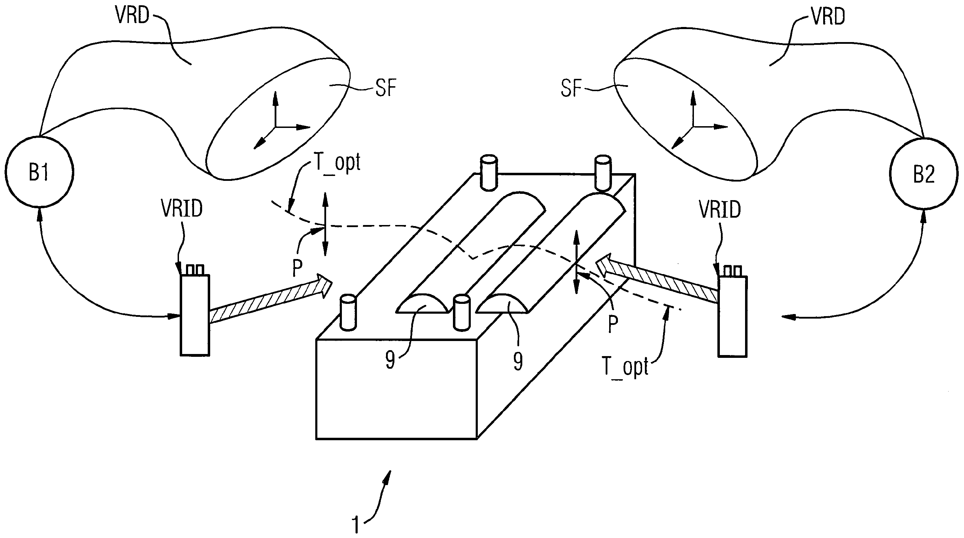

FIG 5 eine mögliche Darstellung für einem Benutzer B. Die Darstellung in FIG 5 und FIG 6 können dem entsprechen, das der Benutzer B bzw. die Benutzer B, B1, B2 sehen. Der Benutzer B trägt eine VR-Anzeigevorrichtung VRD, z. B. eine Virtual Reality Brille (Head-Mounted-Display). Die VR-Anzeigevorrichtung VRD zeigt dem Benutzer B ein Sichtfenster SF. Das Sichtfenster SF zeigt dem Benutzer B einen Ausschnitt der Produktionsmaschine 1 und/oder dem sich, entlang der optimierten Trajektorie T_opt bewegenden, Bauteils 1. Der Benutzer B kann, beispielsweise durch Bewegung seines Kopfes oder durch einen Sprachbefehl die Ausrichtung/Position des Sichtfensters SF verändern. So kann der Benutzer B oder die Benutzerin B die Produktionsmaschine 1 und/oder das Bauteils 1 aus mehreren Richtungen und/oder von mehreren Positionen aus betrachten. Zur Ausrichtung des Sichtfensters SF kann auch eine Sprachsteuerung dienen.

Die optimierte Trajektorie T_opt wird von der der Recheneinheit 13 bereitgestellt. Zur Berechnung der optimierten Trajektorie dient auch hier das Simulationsprogramm S, wobei das Simulationsprogramm S eine Optimierungsroutine Opt aufweist. Die Recheneinheit 13 weist weiter einen Anschluss VRM für die 3D-Anzeige und/oder die VR-Anzeigevorrichtung, insbesondere die Virtual Reality Brille, auf. Die Recheneinheit 13 weist weiter einen Anschluss für den Joystick VRID (Virtual Reality Input Device) auf. Mit Hilfe des Joysticks WVID kann der Benutzer B einen Cursor bewegen. Durch den Cursor kann der Benutzer B die optimierte Trajektorie T_opt verändern. Weiter kann der Benutzer B mit Hilfe des Joysticks VRID die Position und die Ausrichtung des Bauteils 9 und/oder die Position der Produktionsmaschine 1 sowie optional die Position und/oder die Ausrichtung eines Werkzeugs der Produktionsmaschine 1 verändern.

Bewegungen des Werkzeugs der Produktionsmaschine 1 und/oder der optimierten Trajektorie T_opt werden durch in den Figuren als Pfeile P dargestellt. Die Veränderung des Sichtfensters SF wird ebenfalls durch die analog des Dreibeins angeordneten Pfeile symbolisiert.

Die Auswirkungen der Veränderungen, insbesondere der Veränderung der optimierten Trajektorie T_opt, werden dem Benutzer B angezeigt. Kollisionen des Bauteils 1 mit der Produktionsmaschine 1 werden durch eine farbliche Markierung eines Kennzeichens K dem Benutzer angezeigt. Optional kann das Sichtfenster SF des Benutzers automatisiert auf die Kennzeichnung der Kollision gelenkt werden.

FIG 6 eine mögliche Darstellung für zwei Benutzer B1, B2. Die FIG 6 zeigt analog der FIG 5 eine Wechselwirkung eines Benutzers B1, B2 mit der dargestellten optimierten Trajektorie T_opt, der dargestellten Produktionsmaschine 1 und des dargestellten Bauteils 1.

Die Produktionsmaschine 1 und die beiden Bauteile 9 werden dem ersten Benutzer B1 in einem Sichtfenster SF angezeigt und/oder dem zweiten Benutzer B2 in einem Sichtfenster SF angezeigt. Vorteilhaft tragen beide Benutzer B1, B2 eine VR-Anzeigevorrichtung VRD auf, so dass sich die das jeweilige Sichtfenster SF durch die Ausrichtung des virtuellen Realitätsbrille VRD kontrolliert.

Der erste Benutzer B1 und/oder der zweite Benutzer B2 können jeweils mit Hilfe eines Joysticks VRIP oder einer anderen VR-Eingabevorrichtung:
- zumindest bereichsweise den Verlauf der optimierten Trajektorie T_opt,
- die Position und/oder Ausrichtung des Bauteils 9 sowie
- die Position und/oder Ausrichtung eines Werkzeugs der Produktionsmaschine;
verändern. Die Veränderungen führen im Anschluss zu einer Berechnung einer neuen optimierten Trajektorie T_opt. Falls die Trajektorie T_opt, T1 nach der vorstehend ausgeführten Veränderung die ggf. veränderten modifizierten Randbedingungen RB nicht mehr erfüllt wird dies einem Benutzer B1, B2 oder beiden Benutzer B1, B2 dargestellt. Die Darstellung kann durch eine farbliche Markierung des Bereiches erfolgen, der von der Nichteinhaltung der Randbedingung RB betroffen ist.

Beschrieben wird zusammenfassend ein Verfahren, insbesondere durch ein Computerprogramm ausgeführt, bei dem ein eine Produktionsmaschine 1, insbesondere ein Pressensystem, im dreidimensionalen Raum angezeigt wird.

Der Benutzer B, B1, B2 des Computerprogrammprodukts kann direkt mit der angezeigten Produktionsmaschine 1 interagieren.

Der Benutzer B, B1, B2 kann, insbesondere durch eine zumindest teilweise-transparente Darstellung der Produktionsmaschine 1 und/oder des zumindest einen Bauteils 1, von Inneren der Produktionsmaschine 1 die ablaufenden Bewegungen der Produktionsmaschine 1 und/oder des Bauteils 9 betrachten.

Anstelle einer Mausbewegung kann der Benutzer B, B1, B2 mit ein einem Joystick VRID, insbesondere einen Joystick VRID mit einem Bewegungssensor, im 3D-Raum interagieren.

Unter einem Werkzeug einer Produktionsmaschine wird ein Schneidmesser, ein Stempel, eine Handlingsvorrichtung verstanden. Ist die Produktionsmaschine als Presse ausgeführt, ist das Werkzeug beispielsweise ein Schieber, Treiber, ein Niederhalter oder ein Ziehkissen.

Mittel des Drag&Drop-Verfahrens kann der Benutzer B, B1, B2 die Trajektorie T1, T_opt des Bauteils 1, sowie optional eine Verfahrkurve eines Werkzeugs der Produktionsmaschine 1 verändern.

Eine Berechnung einer optimierten Trajektorie (als Raumkurve) T_opt des Bauteils 9 erfolgt im dreidimensionalen (3D) Raum.

Ein Fortschritt des Verfahrens zur Berechnung einer optimierten Trajektorie T_opt kann dem Benutzer B, B1, B2 angezeigt werden.

Kollisionen des Bauteils 9 mit der Produktionsmaschine 1, insbesondere der Pressenwerkzeuge 1 werden dem Benutzer B, B1, B2 oder den Benutzern B1, B2 direkt dargestellt. Eine solche Darstellung kann durch eine Markierung durch ein deutlichs Hervorheben erfolgen.

Vorteilhaft erkennt der Benutzer B, B1, B2 das Auswirken seines Handelns in virtuellen Raum mit Hilfe der VR-Anzeigevorrichtung direkt.

Kollisionen können auch zwischen Werkzeugen der Produktionsmaschine auftreten. Diese sind vorteilhaft ebenfalls angezeigt. Kollisionen bei Werkzeugen einer Produktionsmaschine treten insbesondere bei einer unsachgemäßen Ausrichtung/Position des Bauteils in der Produktionsmaschine auf.

Vorteilhaft kann der Benutzer B, B1, B2 der Erfindung die Berechnung einer optimierten Trajektorie T_opt dergestalt unterstützen, indem er mittels manueller Veränderung des optimierten Trajektorie T_opt, insbesondere mittels eines Drag&Drop-Vorgehensweise, die optimierte Trajektorie T_opt von einem lediglich lokalen Minimum hervorhebt und somit weiter optimiert.

Vorteilhaft kann durch Einsatz der Benutzer B, B1, B2 in seinem Verständnis für die Bewegungsabläufe in Bezug auf die Produktionsmaschine 1 geschult werden.

Als VR-Anzeigevorrichtung oder 3D-Anzeige können Virtual Reality Anzeigevorrichtungen wie Google-Glass, Oculus Rift, Microsoft Hololens oder ein ähnliches Gerät eingesetzt werden. Hierbei ist es unerheblich, ob zur Anzeige virtuelle Realität, Augmented Reality oder Holographie angewandt wird. Vorteilhaft erfolgt der Einsatz von mehreren Joysticks VRID, insbesondere einem Model "Razer Hydra" der Firma Sixense Entertainment oder der Firma Razer.

Insbesondere ergibt sich der Vorteil einer berührlosen Steuerung mit einem solchen Joystick VRID.

Mögliche Anwendungsgebiete der Erfindung sind der Werkzeugbau, die Projektplanung, insbesondere die Planung von Fabrikanlagen, die Bestückung von Pressen 1 oder Presslinien. Weitere Einsatzgebiete der Erfindung können Instandhaltungen und/oder Servicearbeiten, insbesondere an Pressen 1 sein. Besonders vorteilhaft eignet sich die Erfindung zur Schulung von Bedienpersonal/Benutzer B, B1, B2 und Ingenieuren im Bereich Pressen 1.

Im Wesentlichen betrifft die Erfindung ein Verfahren zur Berechnung oder Bereitstellung einer optimierten Trajektorie T_opt mit Hilfe eines Simulationsprogramm S und einer Optimierungsroutine Opt. Während des Verfahrens wird die Trajektorie T, T1, Tw mit Hilfe eines Simulationsprogramms S bereitgestellt und an Randbedingungen RB angepasst. Das Verfahren weist eine Schleife auf, wobei die Schleife - die Bereitstellung der einer ersten Trajektorie T1,
- die Modifikation einer (weiteren) Trajektorie T1, Tw,
- sowie die Anpassung der (weiteren) Trajektorie Tw, T anhand von Randbedingungen RB
als einzelne Schritte aufweist. Die optimierte Trajektorie T_opt ist eine Trajektorie T, Tw, welche anhand eines extremalen oder vorbestimmten Parameter v', v_ex bereitgestellt worden ist. Die optimierte Trajektorie T_opt wird nach der Berechnung einer Steuerungseinrichtung 11 zur Bewegung einer Halterung 7 für ein Bauteil 9 bereitgestellt dadurch gekennzeichnet, dass das sich auf der optimierten Trajektorie T_opt bewegende Bauteil (9) und/oder die Produktionsmaschine 1 einem Benutzer B, B1, B2 mit Hilfe einer 3D-Anzeuge angezeigt wird.

## Patentansprüche

1. Verfahren zur Berechnung einer optimierten Trajektorie (T_opt) mindestens eines Bauteils (9) für einen Transport des Bauteils (9) in eine Produktionsmaschine (1) hinein und/oder aus der Produktionsmaschine (1) heraus, wobei mindestens eine Optimierungsroutine (Opt) einem Simulationsprogramm (S) zugeordnet ist, wobei das Simulationsprogramm (S) ein Einbringen und eine Entnahme des Bauteils (9) in die Produktionsmaschine simuliert, wobei mit dem Simulationsprogramm (S) anhand von Randbedingungen (RB) eine erste Trajektorie (T1) berechnet wird, in der Optimierungsroutine (Opt) aus der ersten Trajektorie (T1) ein Parameter (v), insbesondere eine Geschwindigkeit (v), berechnet wird, wobei mittels der Optimierungsroutine (Opt) ein veränderter Parameter (v') ermittelt wird und zumindest eine weitere Trajektorie (Tw) anhand dem veränderten Parameter (v') erzeugt wird, wobei die weitere Trajektorie (Tw) in einer Schleife verändert wird, wobei die Schleife zumindest folgende Schritte aufweist:
- wobei in einem Schritt mittels des Simulationsprogramms (S) die weitere Trajektorie (Tw) an die Randbedingungen (RB) angepasst wird und der Optimierungsroutine (Opt) zugewiesen wird,
- wobei in einem Schritt auf Grundlage der weiteren Trajektorie (Tw) der Parameter (v) ermittelt wird,
- wobei in einem Schritt auf Grundlage des Parameters (v) der veränderte Parameter (v') ermittelt wird,
- wobei in einem Schritt auf Grundlage des veränderten Parameters (v') die weitere Trajektorie (Tw) berechnet wird und die weitere Trajektorie (Tw) dem Simulationsprogramm (S) zugewiesen wird,
wobei die Schleife so lange durchlaufen wird, bis der veränderte Parameter (v') einen vorgegebenen Wert (v_ex) oder einen extremalen Wert (v_ex) erreicht, wobei die optimierte Trajektorie (T_opt) aus dem extremalen Wert (v_ex) oder dem vorgegebenen Wert (v_ex) berechnet und mit dem Simulationsprogramm (S) an die Randbedingungen (RB) angepasst wird, wobei das zumindest ein Bauteil (9) sowie die Produktionsmaschine (1) in einer 3D-Anzeige (VRD) angezeigt wird,
wobei die Produktionsmaschine (1) und zumindest ein Bauteil (9) in einem dreidimensionalen virtuellen Raum mit Hilfe der 3D-Anzeige (VRD) dargestellt wird, und
wobei zumindest das Bauteil (9) entlang der optimierten Trajektorie (T_opt) bewegt angezeigt wird.

2. Verfahren nach einem der vorangehenden Ansprüche, wobei eine Verletzung der Randbedingungen (RB) bei der Bewegung des Bauteils (9) mit der Produktionsmaschine (1) angezeigt wird.

3. Verfahren nach einem der vorangehenden Ansprüche, wobei die Bewegung des Bauteils (9) und optional die Bewegung der Produktionsmaschine (1) einem Benutzer (B, B1, B2) oder mehreren Benutzern (B, B1, B2) angezeigt.

4. Verfahren nach einem der vorangehenden Ansprüche, wobei zumindest ein Benutzer (B, B1, B2) mit Hilfe zumindest einer VR-Eingabevorrichtung (VRIP) die optimierte Trajektorie (T_opt) verändert, wobei durch die Veränderung die optimierte Trajektorie (T_opt) in eine erste Trajektorie (T1) gewandelt wird, wobei die erste Trajektorie (T1) mit dem Verfahren zur Berechnung einer optimierten Trajektorie (T_opt) gemäß Anspruch 1 wieder optimiert und angezeigt wird.

5. Verfahren nach einem der vorangehenden Ansprüche, wobei die zumindest die Produktionsmaschine (1) und das zumindest eine Bauteil (9) zumindest teilweise transparent angezeigt werden.

6. Verfahren nach einem der vorangehenden Ansprüche, wobei die Ansicht auf die Produktionsmaschine (1) und/oder das Bauteil (1) von mehreren Punkten und/oder von mehreren Ausrichtungen aus angezeigt werden kann, wobei der Benutzer (B, B1, B2) den Punkt und/oder die Ausrichtung wählen kann.

7. Verfahren nach einem der vorangehenden Ansprüche, wobei die Produktionsmaschine (1) und/oder das zumindest eine Bauteil (9) zumindest zwei Benutzern (B, B1, B2) angezeigt werden, wobei eine Nichtbeachtung der Randbedingungen (RB), insbesondere einer Kollision des Bauteils (9) mit der Produktionsmaschine (1), zumindest einem der Benutzer (B, B1, B2) angezeigt wird.

8. Computerprogrammprodukt zur Ausführung des Verfahrens nach einem der vorangehenden Ansprüche, wobei das Computerprogrammprodukt auf einer Recheneinheit (13) zur Ausführung vorgesehen ist.

## Claims

1. Method for calculating an optimized trajectory (T_opt) of at least one component (9) for transporting the component (9) into a production machine (1) and/or out of the production machine (1), wherein at least one optimization routine (Opt) is assigned to a simulation program (S), wherein the simulation program (S) simulates an introduction of the component (9) into the production machine and the removal therefrom, wherein a first trajectory (T1) is calculated using the simulation program (S) on the basis of boundary conditions (RB), a parameter (v), in particular the speed (v), being calculated from the first trajectory (T1) in the optimization routine (Opt), wherein a modified parameter (v') is ascertained by means of the optimization routine (Opt) and at least one further trajectory (Tw) is produced on the basis of the modified parameter (v'), wherein the further trajectory (Tw) is modified in a loop, wherein the loop comprises at least the following steps:
- the further trajectory (Tw) being fitted to the boundary conditions (RB) and assigned to the optimization routine (Opt) in one step by means of the simulation program,
- the parameter (v) being ascertained on the basis of the further trajectory (Tw) in one step,
- the modified parameter (v') being ascertained on the basis of the parameter (v) in one step,
- the further trajectory (Tw) being calculated on the basis of the modified parameter (v') and the further trajectory (Tw) being assigned to the stimulation program (S) in one step,
wherein the loop is run through until the modified parameter (v') reaches a predetermined value (v_ex) or an extremal value (v_ex), wherein the optimized trajectory (T_opt) is calculated from the extremal value (v ex) or the predetermined value (v_ex) and adapted to the boundary conditions (RB) with the simulation program (S), wherein the at least one component (9) and the production machine (1) are displayed in a 3D display (VRD),
wherein the production machine (1) and at least one component (9) are presented in a three-dimensional virtual space with the aid of the 3D display (VRD),
wherein at least the component (1) is displayed moving along the optimized trajectory (T_opt).

2. Method according to the preceding claim, wherein an infringement of the boundary conditions (RB) by the production machine (1) when moving the component (9) is displayed.

3. Method according to either of the preceding claims, wherein the movement of the component (9) and optionally the movement of the production machine (1) is displayed to a user (B, B1, B2) or to a plurality of users (B, B1, B2).

4. Method according to any one of the preceding claims, wherein at least one user (B, B1, B2) modifies the optimized trajectory (T_opt) with the aid of at least one VR input apparatus (VRIP), wherein the optimized trajectory (T_opt) is converted into a first trajectory (T1) by the modification, wherein the first trajectory (T1) is re-optimized and displayed using the method for calculating an optimized trajectory (T_opt) according to claim 1.

5. Method according to any one of the preceding claims, wherein the production machine (1) and the at least one component (9) are displayed at least partly transparently.

6. Method according to any one of the preceding claims, wherein the view of the production machine (1) and/or of the component (9) can be displayed from a plurality of points and/or from a plurality of orientations, wherein the user (B, B1, B2) can choose the point and/or the orientation.

7. Method according to any one of the preceding claims, wherein the production machine (1) and/or the at least one component (9) are displayed to at least two users (B, B1, B2), wherein a non-observance of the boundary conditions (RB), in particular a collision between the component (9) and the production machine (1), is displayed to at least one of the users (B, B1, B2).

8. Computer program product for executing the method according to any one of the preceding claims, when the computer program product is provided on a computing unit (13) for execution purposes.

## Revendications

1. Procédé de calcul d'une trajectoire optimisée (T_opt) d'au moins un composant (9) pour un transport du composant (9) jusque dans une machine de production (1) et/ou hors de la machine de production (1), au moins une routine d'optimisation (Opt) étant associée à un programme de simulation (S), le programme de simulation (S) simulant une introduction dans et un retrait du composant (9) de la machine de production, avec le programme de simulation (S) étant calculée, à l'aide de conditions marginales (RB), une première trajectoire (T1), dans la routine d'optimisation (Opt) étant calculé, à partir de la première trajectoire (T1), un paramètre (v), en particulier une vitesse, au moyen de la routine d'optimisation (Opt) étant calculé un paramètre modifié (v') et au moins une autre trajectoire (Tw) étant générée à l'aide du paramètre modifié (v'), l'autre trajectoire (Tw) étant modifiée dans une boucle, la boucle comportant au moins les étapes suivantes :
- dans une étape, au moyen du programme de simulation (S), l'autre trajectoire (Tw) étant adaptée aux conditions marginales et est associée à la routine d'optimisation (Opt),
- dans une étape, sur la base de l'autre trajectoire (Tw), le paramètre (v) étant déterminé,
- dans une étape, sur la base du paramètre (v), le paramètre modifié (v') étant déterminé,
- dans une étape, sur la base du paramètre modifié (v'), l'autre trajectoire (Tw) étant calculée et l'autre trajectoire (Tw) étant associée au programme de simulation (S),
la boucle étant parcourue jusqu'à ce que le paramètre modifié (v') atteigne une valeur donnée (v_ex) ou une valeur extrémale (v_ex), la trajectoire optimisée (T_opt) étant calculée à partir de la valeur extrémale (v_ex) ou de la valeur donnée (v_ex) et étant adaptée aux conditions marginales (RB) avec le programme de simulation (S), l'au moins un composant (9) et la machine de production (2) étant affichés dans un affichage 3C (VRD),
la machine de production (2) et au moins un composant (9) étant représentés dans un espace virtuel tridimensionnel à l'aide de l'affichage 3D (VRD) et
au moins le composant (9) étant affiché de manière mobile le long de la trajectoire optimisé (T_opt).

2. Procédé selon l'une des revendications précédentes, une violation des conditions marginales (RB) lors du déplacement du composant (9) avec la machine de production (1) étant affichée.

3. Procédé selon l'une des revendications précédentes, le déplacement du composant (9) et, optionnellement, le déplacement de la machine de production (1) étant affichés pour un utilisateur (B, B1, B2) ou pour plusieurs utilisateurs (B, B1, B2).

4. Procédé selon l'une des revendications précédentes, au moins un utilisateur (B, B1, B2) modifiant la trajectoire optimisée (T_opt) à l'aide d'au moins un dispositif d'entrée VR (VRIP), la trajectoire optimisée (T_opt) étant convertie en une première trajectoire (T1) du fait de la modification, la première trajectoire (T1) étant de nouveau optimisée et affichée par le procédé de calcul d'une trajectoire optimisée (T_opt) selon la revendication 1.

5. Procédé selon l'une des revendications précédentes, au moins la machine de production (1) et l'au moins un composant (9) étant affichés au moins en partie de manière transparente.

6. Procédé selon l'une des revendications précédentes, la vue sur la machine de production (1) et/ou le composant (1) pouvant être affichée depuis plusieurs points et/ou depuis plusieurs directions, l'utilisateur (B, B1, B2) pouvant choisir le point et/ou la direction.

7. Procédé selon l'une des revendications précédentes, la machine de production (1) et/ou l'au moins un composant (9) étant affichés pour au moins deux utilisateurs (B, B1, B2), un non-respect des conditions marginales (RB), et plus particulièrement une collision du composant (9) avec la machine de production (1), étant affiché pour au moins l'un des utilisateurs (B, B1, B2).

8. Produit de programme informatique permettant d'exécuter le procédé selon l'une des revendications précédentes, le produit de programme informatique étant prévu pour exécution sur une unité de calcul (13).
